Europäisches Patentamt

(19) European Patent Office

Office européen des brevets

(11) Publication number : **0 653 800 A2**

(12) **EUROPEAN PATENT APPLICATION**

(21) Application number : 94308441.8

(22) Date of filing : 15.11.94

(51) Int. Cl.$^6$ : **H01P 5/12, H03H 7/48**

(30) Priority : **15.11.93 JP 307049/93**

(43) Date of publication of application :
**17.05.95 Bulletin 95/20**

(84) Designated Contracting States :
**DE FR GB IT**

(71) Applicant : **KOKUSAI ELECTRIC CO., LTD.**
**14-20, 3-chome Higashinakano,**
**Nakano-ku**
**Tokyo-To (JP)**

(72) Inventor : **Sasaki, Kanemi**
**2-8-18 Momijigaoka,**
**Yamato-machi**
**Kurokawa-gun, Miyagi-ken (JP)**

(74) Representative : **Crawford, Fiona Merle et al**
**Elkington and Fife**
**Prospect House**
**8 Pembroke Road**
**Sevenoaks, Kent TN13 1XR (GB)**

(54) **Wide-band power branch/combiner.**

(57)    A power branch/combiner which branches high-frequency wide-band power into two or greater prime number N of ways or for combining high-frequency wide-band power from N ways and which is free from interference by a difference in the power to N inputs and is simple-structured. Unbalance absorbing resistors ($R_1$ to $R_N$) connected together at one end are connected at the other end to respective individual ports (1 to N) and wide-band individual transformers ($T_1$ to $T_N$).

*Fig. I*

$T_1 \sim T_N$ : INDIVIDUAL PORT TRANSFORMER
$R_1 \sim R_N$ : UNBALANCE ABSORBING RESISTOR
$P_1 \sim P_N$ : INDIVIDUAL PORT APPLIED POWER

EP 0 653 800 A2

The present invention relates to a power branch/combiner for use in telecommunication facilities and, more particularly, to a power branch/combiner for branching high-frequency power of the microwave band into a plurality of ways in in-phase relation over a wide band or combining power from a plurality of systems.

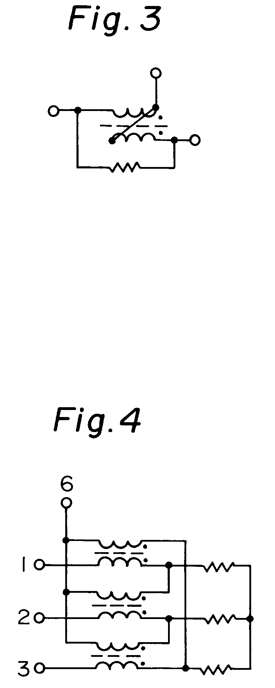

In general, a high-frequency power branch/combiner is a hybrid circuit composed of a transmission line typed wide-band transformer and a resistor, and a wide-band power two-way branching/combining circuit shown in Fig. 3 of the accompanying drawings or a wide-band power three-way branching/combining circuit is used as an elementary circuit; wide-band power branch/combiners are mostly formed by a parallel or cascade connection of such circuits.

With the above-mentioned circuits, however, it is possible to implement branching power into a prime number of ways equal to or greater than 5, such as 5, 7, 11, 13, ... and combining power therefrom; it is necessary to employ a branching/combining circuit corresponding to each prime number. Among others, a wide-band power five-way branching/combining circuit permits branching power into numbers which have a factor of 5, such as 10, 15, 20, ..., 100, ..., and combining power from such plural ways, and it has become particularly important in recent years of highly developed multiplex communication.

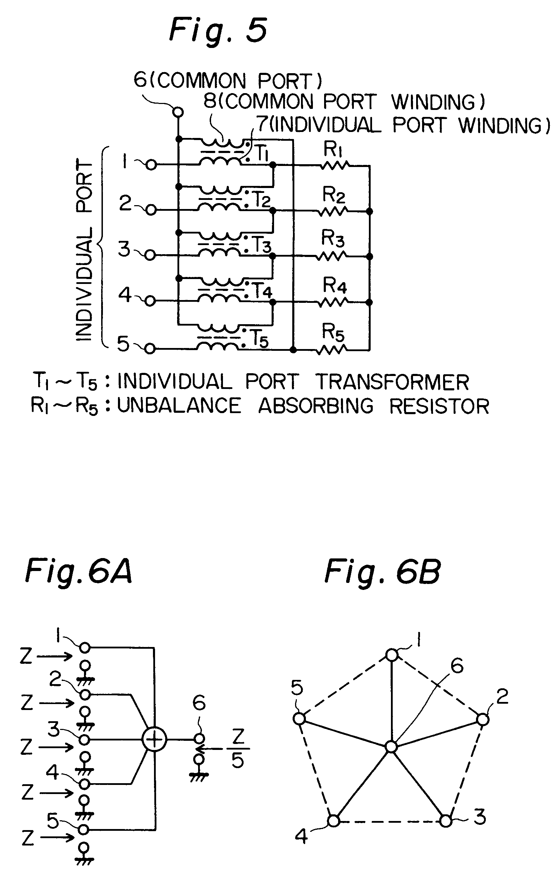

As a wide-band power branching/combining circuit for branching power into a prime number of ways equal to or greater than 5 and combining power therefrom, there has been proposed a developed version of the three-way branch/combiner circuit depicted in Fig. 4 of the accompanying drawings. An example is shown in Fig. 5 of the accompanying drawings.

In Fig. 5, reference numerals 1, 2, 3, 4 and 5 denote individual ports, 6 a common port, $T_1$ through $T_5$ wide-band individual port transformers, 7 an individual port winding of the transformer $T_1$, 8 a common port winding of the transformer $T_1$, 8 a comon port winding of the transformer $T_1$ and $R_1$ through $R_5$ unbalance absorbing resistors.

This circuit can generally be represented by an equivalent circuit shown in Fig. 6A. It is important, in this circuit, that when the load impedance connected to the common port 6 or internal impedance of a signal source is Z/5, the input impedance or internal impedance of each of the individual ports 1 through 5 is Z and the individual ports are each isolated and free from interference from the others.

In the circuit of Fig. 5, however, the individual port windings of the individual port transformers and the common port winding are connected as indicated by the broken lines in Fig. 6B which join adjacent vertexes of a pentagon with the individual ports 1 through 5 as the vertexes. With such an arrangement, the individual port transformer winding of each individual port is connected only to the individual port transformer windings of the two adjoining individual ports and are not connected to the other remaining two individual ports. This poses such problems as described below.

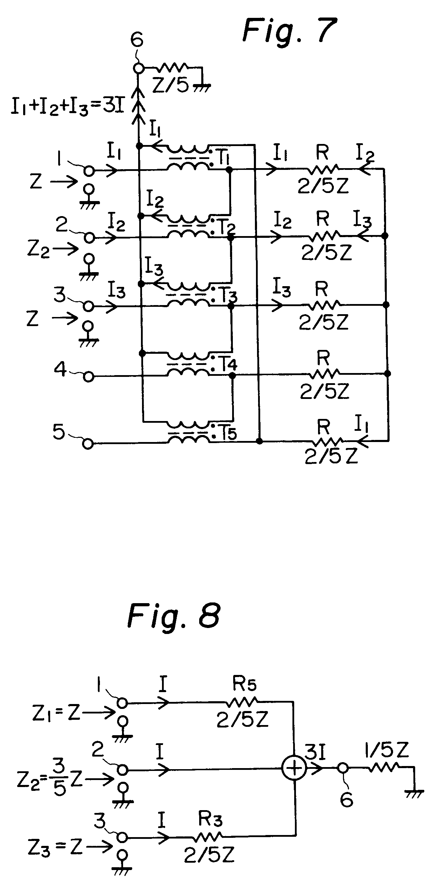

That is, in the case of the circuit of Fig. 5 being used as a wide-band power branch/combiner, letting the terminating resistance value of the common port be represented by Z/5 and the value of each of the unbalance absorbing resistors $R_1$ to $R_5$ by (2/5)Z, when a current I is fed to each individual port, the input power is wholly consumed by the terminating resistance of the common port and the input impedance viewed from each individual port is Z. When currents $I_1$, $I_2$, $I_3$ = I are fed to the three individual ports 1, 2 and 3 alone, the currents flow therethrough as shown in Fig. 7; because of the currents $I_1$ and $I_3$, power is consumed by the resistors $R_5$ and $R_3$ as well. Fig. 8 shows an equivalent circuit in this case. The impedances $Z_1$ and $Z_3$ viewed from the individual ports 1 and 3 are both Z in this instance but the impedance $Z_2$ viewed from the individual port 2 is reduced to (3/5)Z.

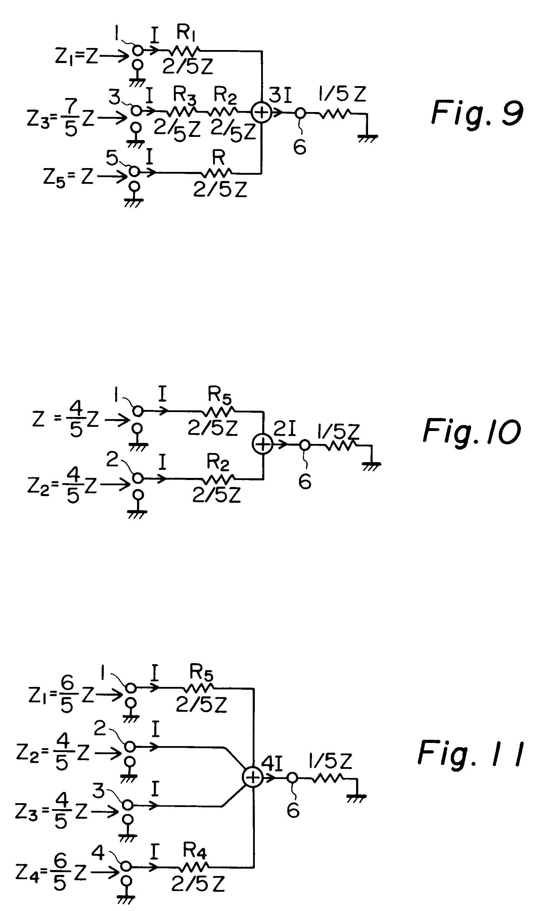

Fig. 9 shows an equivalent circuit in the case of the same current being applied to the three individual ports 1, 3 and 5 alone in Fig. 5; in this instance, the impedances $Z_1$ and $Z_5$ are both Z but the impedance $Z_3$ viewed from the individual port 3 is increased to (7/5)Z. Fig. 10 shows an equivalent circuit in the case of currents being fed to the two individual ports 1 and 2; the impedances $Z_1$ and $Z_2$ are both (4/5)Z. Fig. 11 shows an equivalent circuit in the case of currents being fed to the four individual ports 1, 2, 3 and 4; the impedances $Z_1$ and $Z_4$ are both (6/5)Z and those $Z_2$ and $Z_3$ are both (4/5)Z.

As described above, when the five-way branch/combiner of Fig. 5 or a wide-band power n-way branch/combiner is used as a wide-band power combiner, a difference in power fed to each individual port causes a substantial change in the input impedances of other individual ports, affecting the operation of a power amplifier which feeds power to each individual port and causing interference between such power amplifiers. Hence, the above-mentioned power branch/combiner is unsatisfactory as a power combiner.

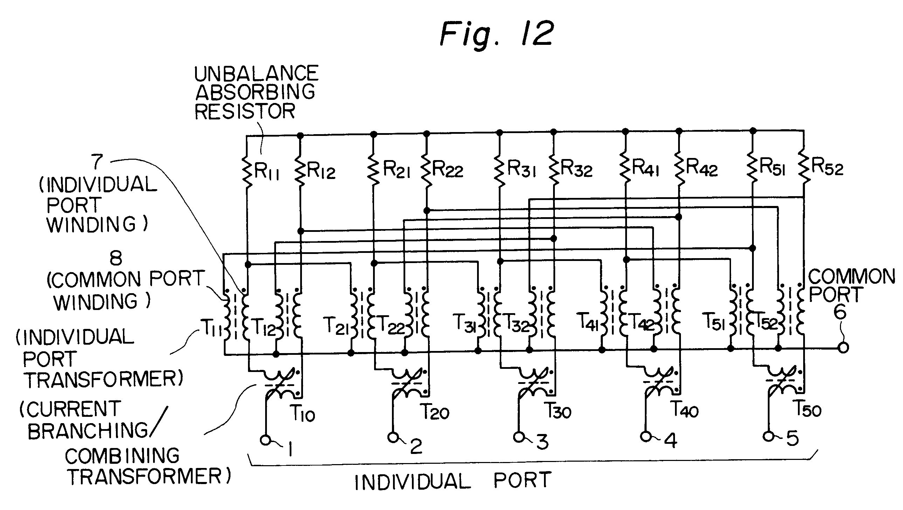

To obviate these defects, a means is proposed in Japanese Pat. Pub. No. 16768/93. Fig. 12 illustrates a five-way branch/combiner circuit which is an embodiment of the proposed means. In the illustrated circuit, the input impedance viewed from each individual port is made constant regardless of the difference in power fed from each individual port, avoiding interference between the power amplifiers which feed power to respective individual ports.

According to the proposed scheme, a wide-band power branching/combining circuit which has a prime

number $\underline{n}$ of individual ports and one common port is characterized in that: each individual port has (n-1)/2 transmission line typed wide-band individual port transformers each having a pair of common port windings (7) and (8); the individual port winding (7) is connected at one end to the individual port and at the other end to the common port winding of the individual port transformer of another individual port and one end of an unbalance absorbing resistor the other end of which is connected to the individual port winding (7) and the common port winding (8) of said another individual port in common to them; and the common port winding (8) pairing with the individual port winding (7) is connected at one end to the common port (6) and at the other end to the individual port winding (7) of the individual port transformer of another individual port. Thus, the windings of each individual port transformer of each individual port are connected to the windings of the individual port transformers of other individual ports.

As is evident from comparison of Figs. 5 and 12 with each other, however, the circuit of Fig. 12 is complex and the number of parts needed is more than twice as large as that needed for the Fig. 5 circuit; therefore, the circuit of Fig. 12 is uneconomical and hence is impractical.

An object of the present invention is to provide a wide-band power branch/combiner which enables individual ports to be sufficiently isolated from one another to prevent interference between power amplifiers and permits reduction of the number of parts used as compared with that in the prior art.

The wide-band power branch/combiner according to the present invention has its main feature in that the unbalance absorbing resistor is disposed at the individual port side. With this arrangement, the individual port is connected via the unbalance absorbing resistor to all of the other individual ports; by selecting the resistance value to be equal to the individual port impedance Z, the individual port is isolated from the others. This solves the problem that a difference in power to each individual port causes changes in the input impedances of the other individual ports.

The wide-band power branch/combiner according to the present invention comprises: a plurality of individual ports and one common port for branching high-frequency power into a plurality of ways in in-phase relation over a wide band or for combining high-frequency power from a plurality of ways over a wide band; a plurality of wide band individual port transformers each having an individual port winding and a common port winding; and a plurality of unbalance absorbing resistors each connected at one end to the winding of one of the wide-band individual port transformers and at the other end connected to the other ends of the other unbalance absorbing resistors. The wide-band individual transformers each have the individual port winding connected at one end to one of the plurality of individual ports and have the common port connected at one end to the common port, and the other end of the individual port winding is connected to the other end of the common port winding of the next wide-band individual port transformer. This wide-band power branch/combiner is characterized in that the plurality of unbalance absorbing resistors are connected at one end to the plurality of individual ports, respectively.

Furthermore, the wide-band power branch/combiner according to an aspect of the present invention comprises: five individual ports and one common port for branching high-frequency power into five ways in in-phase relation over a wide band or for combining high-frequency power from five ways over a wide band; and five wide-band individual port transformers each having its individual port winding connected at one end to one of the five individual ports, having its common port winding connected at one end to the common port and having the individual port winding connected at the other end to the other end of the common port winding of the wide-band individual transformer of the next port. This power branch/combiner is characterized by the provision of five unbalance absorbing resistors connected at one end to the five individual ports, respectively, and connected together at the other ends.

Embodiments of the present invention will now be described, by way of example, with reference to the accompanying drawings, in which:

Fig. 1 is a circuit diagram illustrating an embodiment of the present invention;

Fig. 2 is a circuit diagram illustrating a further embodiment of the present invention;

Fig. 3 is a diagram illustrating an example of a conventional two-way branch/combiner circuit;

Fig. 4 is a diagram illustrating an example of a conventional three-way branch/combiner circuit;

Fig. 5 is a diagram illustrating an example of a conventional five-way branch/combiner circuit;

Fig. 6 is an equivalent circuit diagram of the Fig. 5 circuit and a transformer connection diagram;

Fig. 7 is a diagram explanatory of one operation of the Fig. 5 circuit;

Fig. 8 is an equivalent circuit diagram of the Fig. 7 circuit

Fig. 9 is an equivalent circuit diagram explanatory of another operation of the Fig. 5 circuit;

Fig. 10 is an equivalent circuit diagram explanatory of another operation of the Fig. 5 circuit;

Fig. 11 is an equivalent circuit diagram explanatory of another operation of the Fig. 5 circuit;

Fig. 12 is a diagram showing an example of a conventional circuit having characteristics improved from those of the Fig. 5 circuit; and

Fig. 13 is a diagram showing another conventional circuit.

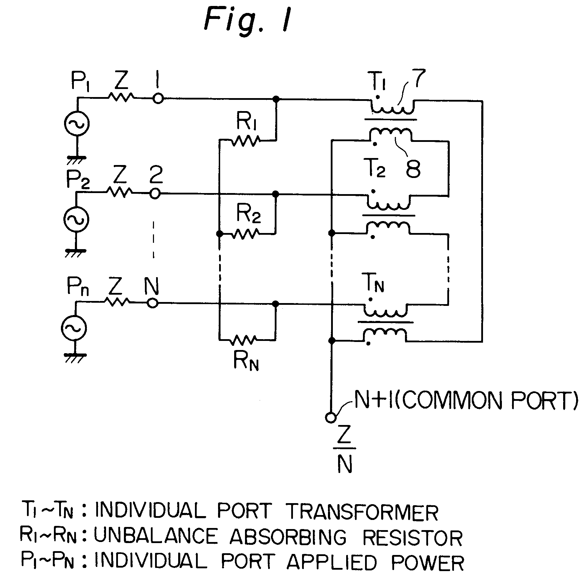

With reference to Fig. 1, an embodiment of the present invention is now described, in which the number of individual ports is two or more. Reference numeral 1, 2, ..., N denote individual ports, N+1 a common port, $T_1$, $T_2$, ..., $T_N$ wide-band individual port transformers, the black dot "." the start of turn of each winding and $R_1$, $R_2$, ..., $R_N$ unbalance absorbing resistors. Reference characters $P_1$, $P_2$, ..., $P_N$ denote power applied to respective individual ports, and Z the impedance of each individual port. When the individual port impedance Z is equal to the unbalance resistance ($R_1 = R_2 = .... = R_N = Z$), the impedance of the common port N+1 is Z/N. It has been ascertained experimentally that this configuration provides sufficient isolation of each individual port from the others. Incidentally, the winding of the wide-band individual port transformer is formed by a coaxial cable in the high-frequency band.

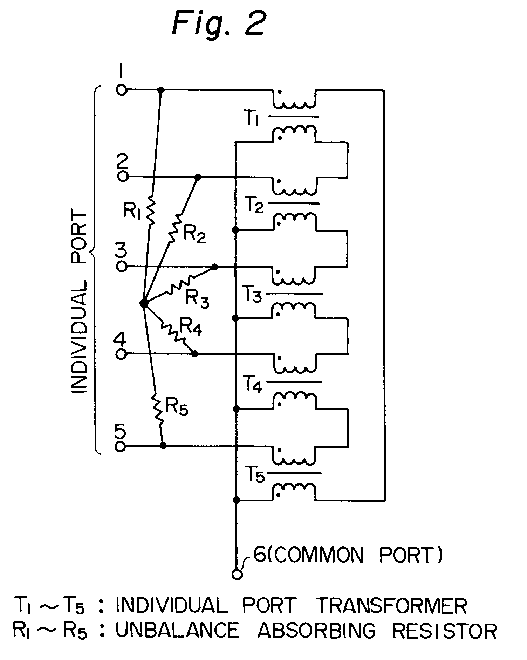

Fig. 2 is a circuit diagram illustrating another embodiment of the present invention. Reference numerals 1, 2, ..., 5 denote individual ports, 6 a common port, $T_1$, $T_2$, ..., $T_5$ wide-band individual port transformers, the black dot "." the start of turn of each winding and $R_1$, $R_2$, ..., $R_5$ unbalance absorbing resistors.

The power that is applied to the individual ports of this circuit and measured values of combined output power from the common port 6 and the power consumed by the absorbing resistors are shown in Table 1. When the value of the absorbing resistor is equal to the impedance Z of the individual port, the load impedance of the common port 6 for obtaining the combined output is Z/5.

Table 1

| Power applied to individual port (W) | | | | | Output power from common port 6 (W) | Power $P_{Ri}$ consumed by absorbing resistors (W) | | | | | |
|---|---|---|---|---|---|---|---|---|---|---|---|
| 1 | 2 | 3 | 4 | 5 | | $\Sigma P_{Ri}$ | $R_1$ | $R_2$ | $R_3$ | $R_4$ | $R_5$ |
| 100 | 100 | 100 | 100 | 100 | 500 | 0 | 0 | 0 | 0 | 0 | 0 |
| 0 | 100 | 100 | 100 | 100 | 320 | 80 | 64 | 4 | 4 | 4 | 4 |
| 0 | 0 | 100 | 100 | 100 | 180 | 120 | 36 | 36 | 16 | 16 | 16 |
| 0 | 0 | 0 | 100 | 100 | 80 | 120 | 16 | 16 | 16 | 36 | 36 |
| 0 | 0 | 0 | 0 | 100 | 20 | 80 | 4 | 4 | 4 | 4 | 64 |

As is evident from Table 1, the sum of the output power from the common port 6 and the total sum $\Sigma P_{Ri}$ of power consumed by the absorbing resistors $R_1$-$R_5$ is equal to the sum of the power fed to the individual ports. This indicates that the individual ports are sufficiently isolated from one another.

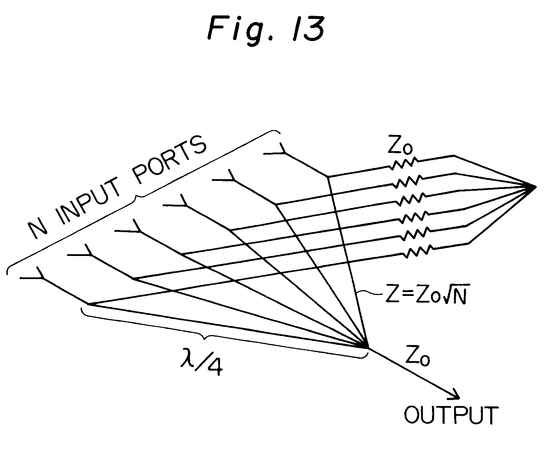

The power branch/combiner according to the present invention is like a Wilkinson type power branch shown in Fig. 13 in the operation of sufficiently isolating the individual ports.

The Wilkinson type power branch inevitably requires a $\lambda/4$ transformer and is limited in the working frequency band to the vicinity of a $\lambda/4$ wavelength, and hence has the defect of narrow band.

In contrast thereto, according to the present invention, the individual port transformers are not grounded but held floating off the ground as shown in Fig. 1; this provides increased isolation of the respective individual ports and implements the power branching/ combining capability over a wide band.

The present invention produces such effects as listed below.

(1) While the electrical characteristics are the same as those of the prior art example of Fig. 12, the number of parts used is the same as that in the prior art of Fig. 5; thus the device of the present invention is substantially simplified in structure and is very economical.

(2) The reduction of the number of parts permits simplification of the structure.

(3) Since the value of the absorbing resistor may be equal to the individual port impedance, there is no need of using resistors of specific values as in the past and the power branch/combiner is easily available.

(4) It is possible to implement power branch/combiners for branching power into any desired number of ways and for combining power from any desired number of ways.

## Claims

1. A wide-band power branch/combiner which comprises: a plurality of individual ports (N) and one common port (N+1) for branching high-frequency power into a plurality of ways in in-phase relation over a wide band or for combining high-frequency power from a plurality of ways over a wide band; a plurality of wide-band individual port transformers ($T_N$) each having an individual port winding and a common port winding; and a plurality of unbalance absorbing resistors ($R_1$, $R_2$,....$R_N$), each connected at one end to the winding of a respective one of the wide-band individual port transformers and at the other end to the other resistors; and

   in which each of the plurality of wide-band individual port transformers has the individual port winding connected at one end to a respective one of the plurality of individual ports, has the common port winding connected at one end to the common port and has the other end of the individual port winding connected to the other end of the common port winding of the next wide-band individual port transformer, and each of the plurality of said unbalance absorbing resistors is connected at said one end to a respective one of the plurality of individual ports.

2. A wide-band power branch/combiner which comprises: five individual ports (1~5) and one common port (6) for branching high-frequency power into five ways in in-phase relation over a wide band or for combining high-frequency power from five ways over a wide band; five wide-band individual port transformers ($T_1$~$T_5$) each having an individual port winding and a common port winding; and five unbalance absorbing resistors ($R_1$~$R_5$) each connected at one end to a respective one of the wide-band individual port transformers, and connected together at the other end; and

   in which each of the five wide-band individual port transformers has the individual port winding connected at one end to a respective one of the five individual ports, has the common port winding connected at one end to the common port and has the other end of the individual port winding connected to the other end of the common port winding of the next wide-band individual port transformer, and each of the five unbalance absorbing resistors ($R_1$~$R_5$) is connected at one end to a respective one of the five individual ports.

## Fig. 1

T₁~T_N : INDIVIDUAL PORT TRANSFORMER
R₁~R_N : UNBALANCE ABSORBING RESISTOR
P₁~P_N : INDIVIDUAL PORT APPLIED POWER

# Fig. 2

$T_1 \sim T_5$ : INDIVIDUAL PORT TRANSFORMER
$R_1 \sim R_5$ : UNBALANCE ABSORBING RESISTOR

# Fig. 3

# Fig.4

# Fig. 5

6(COMMON PORT)
8(COMMON PORT WINDING)
7(INDIVIDUAL PORT WINDING)

INDIVIDUAL PORT

$T_1 \sim T_5$ : INDIVIDUAL PORT TRANSFORMER
$R_1 \sim R_5$ : UNBALANCE ABSORBING RESISTOR

# Fig. 6A

# Fig. 6B

10

## Fig. 7

## Fig. 8

Fig. 9

Fig. 10

Fig. 11

Fig. 12

# Fig. 13

N INPUT PORTS

$Z_0$

$Z = Z_0\sqrt{N}$

$Z_0$

$\lambda/4$

OUTPUT